(19) Europäisches Patentamt
European Patent Office
Office européen des brevets

(11) **EP 2 668 064 B1**

(12) **FASCICULE DE BREVET EUROPEEN**

(45) Date de publication et mention
de la délivrance du brevet:
**22.07.2015 Bulletin 2015/30**

(21) Numéro de dépôt: **12705353.6**

(22) Date de dépôt: **23.01.2012**

(51) Int Cl.:
***B60L 11/18*** *(2006.01)*   ***H02J 7/00*** *(2006.01)*

(86) Numéro de dépôt international:
**PCT/FR2012/050136**

(87) Numéro de publication internationale:
**WO 2012/101366 (02.08.2012 Gazette 2012/31)**

(54) **PROCEDE DE GESTION DE LA CHARGE D'UNE BATTERIE RECHARGEABLE D'UN VEHICULE AUTOMOBILE**

STEUERUNG VERFAHREN EINER KRAFTFAHRZEUGS AKKUMULATOR

METHOD FOR MANAGING THE CHARGING OF A RECHARGEABLE BATTERY OF A MOTOR VEHICLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.01.2011 FR 1150543**

(43) Date de publication de la demande:
**04.12.2013 Bulletin 2013/49**

(73) Titulaire: **Renault S.A.S.**
**92100 Boulogne-Billancourt (FR)**

(72) Inventeurs:
• **SAINT-MARCOUX, Antoine**
**F-91120 Palaiseau (FR)**
• **LE VOURCH, Yves**
**F-78150 Le Chesnay (FR)**
• **DEBERT, Maxime**
**F-78000 Versailles (FR)**

(56) Documents cités:
**EP-A1- 2 131 440    US-A1- 2009 058 366**
**US-B1- 6 285 163    US-B1- 6 486 637**

**Description**

La présente invention concerne un procédé de gestion de la charge d'une batterie rechargeable comprenant au moins un module incluant un couple de cellules électrochimiques ou un procédé de fonctionnement d'un dispositif de gestion de la charge d'une batterie rechargeable comprenant au moins un module incluant un couple de cellules électrochimiques. L'invention porte aussi sur un dispositif mettant en oeuvre un tel procédé et sur un véhicule automobile comprenant un tel dispositif. L'invention porte encore sur un support de données destiné à la mise en oeuvre d'un tel procédé.

Il est connu d'arrêter la charge d'une batterie de véhicule électrique lorsque la tension mesurée aux bornes d'un couple de cellules en parallèle dépasse un seuil. Au vue de la dangerosité d'une surcharge, il est nécessaire que cet arrêt soit le plus fiable possible. La fiabilité intrinsèque d'un capteur de tension utilisée pour cette mesure, bien que très bonne, ne suffit pas à garantir l'arrêt d'une charge dans tous les cas. Il s'ensuit que dans certains cas, il y a surcharge d'une cellule. Ceci se traduit par l'amorçage de réactions parasites pouvant détériorer la batterie, voire détruire la fonctionnalité de la batterie. Plus gênant encore, les réactions parasites peuvent dégager des gaz nocifs. En outre, si le flux de chaleur produit par les réactions exothermiques dépasse le flux de chaleur dissipée par les cellules dans l'environnement extérieur, alors il se produit un emballement thermique, ayant pour conséquence la destruction plus ou moins violente de la batterie même si la charge de la batterie est arrêtée.

Comme expliqué précédemment, si l'arrêt d'une charge s'effectue via une mesure de tension et que cette mesure est défaillante, les courants de charge de la batterie peuvent ne pas être stoppés ou ne pas être stoppés à temps.

Pour palier à cette éventualité, une solution actuelle consiste à mesurer la tension par deux systèmes complètement indépendants et redondants.

Par ailleurs, il apparaît tout à fait intéressant de définir et d'utiliser un indicateur fiable de détection de surcharge de cellules, via l'utilisation d'une mesure de la température d'un module, afin d'arrêter à temps tout courant de surcharge de la batterie. Cet indicateur est ensuite utilisé dans une logique de détection de surcharge pour arrêter la charge à temps. Cet indicateur peut être un complément indépendant d'une logique d'arrêt de la charge gérée par un calculateur de gestion de la batterie.

Il a été remarqué que l'utilisation directe de la mesure de la température ne peut suffire à la détection de la surcharge. Des études ont montré qu'il n'est pas possible de détecter, à partir d'une mesure de température, une surcharge avant l'emballement thermique. En effet, une telle stratégie impliquerait d'utiliser des seuils de température bas qui iraient à l'encontre de l'optimisation de l'utilisation de la batterie et donc à l'encontre de la disponibilité du véhicule. L'utilisation d'une mesure de température pour stopper une charge de batterie est décrite dans les documents suivants : US20050137823, JP2010016944 et

FR2926165. L'estimation de la résistance interne d'une batterie en fonction de la température et la commande de charge s'y afférant est divulguée dans les documents EP2131440, US2009/058366 et US6285163.

Le but de l'invention est de fournir un procédé de gestion de charge permettant de remédier aux problèmes évoqués précédemment et améliorant les procédés de gestion de charge connus de l'art antérieur. En particulier, l'invention propose un procédé de gestion de charge permettant une utilisation fiable et optimale de la batterie.

Selon l'invention, le procédé permet de gérer la charge d'une batterie rechargeable comprenant au moins un module incluant au moins une cellule électrochimique. Il comprend une phase d'estimation d'un flux de chaleur produit dans l'au moins un module par utilisation d'un observateur estimant la résistance interne globale des cellules du module.

La phase d'estimation peut comprendre une étape de définition d'un modèle thermique de l'au moins un module contenant l'au moins une cellule et/ou une étape de mesure d'une température de l'au moins un module contenant l'au moins une cellule.

On peut utiliser l'estimation du flux de chaleur produit dans l'au moins un module pour déterminer une commande d'arrêt de la charge de l'au moins un module ou de la batterie.

On peut arrêter la charge de l'au moins un module ou de la batterie lorsque la résistance interne globale estimée dépasse un seuil prédéterminé ou est significativement différente des résistances internes estimées dans d'autres modules.

L'invention concerne aussi un support d'enregistrement de données lisible par un calculateur sur lequel est enregistré un programme informatique comprenant des moyens de codes de programme informatique de mise en oeuvre des phases et/ou des étapes du procédé de gestion défini précédemment.

Selon l'invention, un dispositif de gestion de la charge d'une batterie rechargeable comprenant au moins un module incluant au moins une cellule électrochimique est caractérisé en ce qu'il comprend des moyens matériels et/ou logiciels de mise en oeuvre du procédé de gestion défini précédemment.

Les moyens matériels et/ou logiciels peuvent comprendre un moyen d'estimation du flux de chaleur produit dans l'au moins un module.

Le moyen d'estimation du flux de chaleur produit dans l'au moins un module peut comprendre un moyen de mesure d'une température du module comprenant ladite une ou plusieurs cellules et un moyen de modélisation thermique de l'au moins une cellule.

Le dispositif peut comprendre un chargeur de batterie et un moyen de pilotage du chargeur de batterie et/ou un interrupteur commandé pour connecter ou déconnecter le chargeur de batterie à l'au moins un module.

Selon l'invention, un véhicule automobile, en particulier véhicule automobile électrique ou hybride, comprend un dispositif défini précédemment.

Selon l'invention, un programme informatique comprend un moyen de code de programme informatique adapté à la réalisation des phases et/ou des étapes du procédé défini précédemment, lorsque le programme tourne sur un ordinateur ou un calculateur embarqué.

Les dessins annexés représentent, à titre d'exemple, un mode de réalisation d'un dispositif de gestion de charge mettant en oeuvre un mode d'exécution du procédé de gestion selon l'invention.

La figure 1 est un schéma d'une batterie électrique et d'un mode de réalisation d'un dispositif de gestion de charge selon invention.

La figure 2 est un schéma d'une architecture logique d'un mode de réalisation d'un dispositif de gestion de charge selon invention.

La figure 3 est un schéma d'une première évolution temporelle d'un critère de détection de surcharge.

La figure 4 est un schéma d'une deuxième évolution temporelle du critère de détection de surcharge.

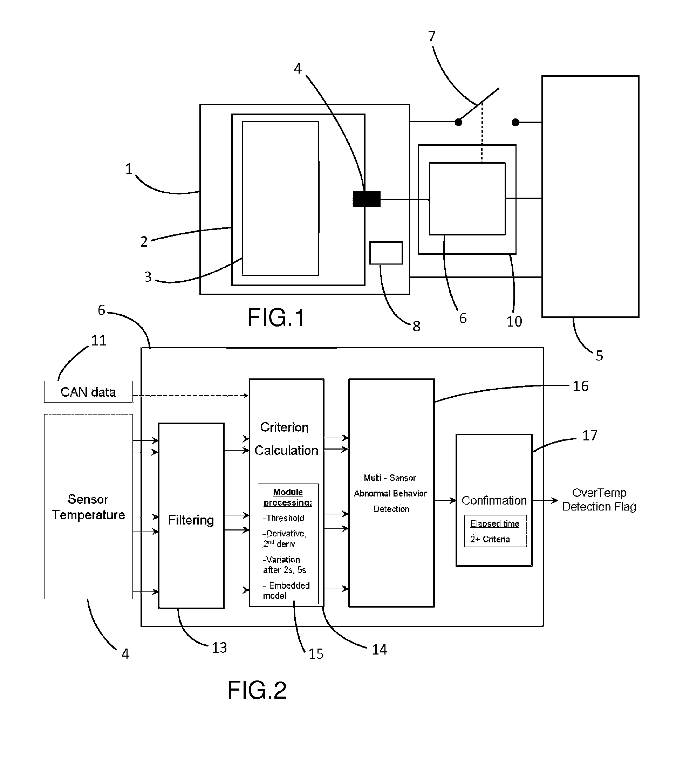

Une installation, représentée à la figure 1, comprend une batterie électrique rechargeable 1, un chargeur 5 et un dispositif 10 de gestion de la charge de la batterie. Ainsi, la batterie peut être chargée grâce au chargeur sous contrôle du dispositif de gestion de la charge.

La batterie peut être de tout type. De préférence, il s'agit d'une batterie d'un véhicule automobile, notamment une batterie d'alimentation d'un moteur électrique d'entraînement d'un véhicule électrique ou d'un véhicule hybride.

La batterie comprend un ou plusieurs modules 2 renfermant, dans un boîtier, une ou plusieurs cellules électrochimiques 3 ou accumulateurs électrochimiques. Les différentes cellules électrochimiques d'un même module sont électriquement reliées entre elles. De même, les différents modules de la batterie sont électriquement reliés entre eux. Par ailleurs, la batterie comprend un calculateur 8 de gestion de la batterie. La batterie permet de fournir, entre ses deux bornes, une énergie électrique et est apte à recevoir, entre ses deux bornes, une énergie électrique lorsqu'on la charge. Le calculateur 8 comprend un moyen de gestion de la charge permettant notamment de détecter une situation de fonctionnement normal dans laquelle il doit être mis fin à la charge de la batterie sans qu'il ne se produise pour autant un dysfonctionnement. Ce moyen de gestion permet également de commander un tel arrêt de la charge.

Le chargeur peut être de tout type. Il est adapté aux caractéristiques de la batterie qu'il est destiné à charger. Il peut être relié à la batterie ou déconnecté de la batterie grâce à un interrupteur commandé 7.

Le dispositif 10 de gestion de la charge de la batterie permet notamment de détecter une situation dans laquelle la batterie est chargée et, éventuellement, de commander un arrêt de la charge de la batterie par le chargeur. Pour ce faire, le dispositif de gestion de la charge comprend des moyens matériels et/ou logiciel de mise en oeuvre du procédé de gestion de charge selon l'invention. En d'autres termes, il comprend des moyens matériels et/ou logiciel permettant de régir son fonctionnement conformément au procédé objet de l'invention.

Le dispositif de gestion comprend un calculateur 6 ou un moyen de pilotage décrit ci-après en référence à la figure 2. Le calculateur est par exemple attaqué par un signal de mesure de température d'un module et, éventuellement, par d'autres signaux circulant sur un bus de données 11. Le signal de mesure de température est filtré grâce à un moyen de filtrage 13. Le signal de mesure filtrée et les éventuels autres signaux circulant sur le bus de données 11 sont ensuite fournis à un moyen de calcul 14 comprenant notamment un modèle thermique 15 du module. Ce moyen de calcul génère un signal fourni à un moyen 16 de détection d'un fonctionnement anormal du module. Ce moyen de détection fournit en sortie un signal logique traduisant un fonctionnement normal ou un fonctionnement anormal du module, notamment un signal traduisant que la batterie est ou non en surcharge. Ce signal logique est fourni à un moyen 17 de validation permettant de valider le signal logique mentionné précédemment et fournissant en sortie un signal indiquant ou non que la batterie est en surcharge. Le moyen de validation peut par exemple valider le signal logique l'attaquant, si ce signal logique est présent en entrée pendant un temps prédéterminé de manière continue.

Le signal fourni en sortie du moyen de validation 17 permet de piloter le chargeur et/ou de piloter un interrupteur commandé 7 permettant de connecter ou de déconnecter le chargeur 5 de la batterie 1.

De préférence, l'interrupteur commandé fait partie du dispositif de gestion de la charge. De même, de préférence, le moyen 4 de détermination de la température fait partie du dispositif de gestion de la charge.

Un mode d'exécution du procédé de gestion de la charge selon l'invention est décrit ci-après.

Comme vu précédemment, quand une cellule de batterie est surchargée, le surplus d'énergie transféré à la cellule active des réactions parasites non désirées. Ces réactions parasites donnent lieu à des formations de gaz et à un comportement anormal de la température. C'est ce comportement qui est analysé dans le procédé selon l'invention. Il repose sur la détection d'une situation anormale de la température telle que la surcharge peut encore être arrêtée à temps. Une information de température mesurée par un capteur seul n'est pas suffisante pour détecter suffisamment tôt la surcharge, c'est-à-dire avant l'emballement thermique, en particulier dans un contexte où celui-ci n'est pas toujours bien positionné..

Pour anticiper cet emballement thermique, il faudrait dériver le signal de température afin de connaître le gradient de température. Ce gradient de température serait un indicateur intéressant pour arrêter la charge. Malheureusement, cette dérivation ne fait qu'amplifier le bruit de mesure.

Dès lors, la détection de situation anormale repose de préférence sur une modélisation des transferts thermiques au niveau d'un module pour déterminer le plus proprement possible (par rapport aux constantes de temps intrinsèques du système étudié) une information thermique.

Le principe consiste à estimer la résistance interne d'un ensemble de cellules d'un module considéré à partir de différentes informations :

- une information de température,
- une information de courant de la batterie et
- des informations de refroidissement d'un module.

Comme il sera vu plus bas, ceci revient à estimer le flux de chaleur produit dans le module.

L'information de température est par exemple donnée par un capteur de température (nécessaire sur un module, sur plusieurs modules ou sur chaque module).

L'information de courant de la batterie est par exemple calculée en fonction de la tension et de la puissance du chargeur (disponible sur le bus de données). L'incertitude sur l'information relative au courant est prise en compte dans la solution proposée : un observateur est calibré pour être robuste vis-à-vis de cette incertitude.

Les conditions de refroidissement sont apprises pour définir le modèle thermique du module et renseignées en ligne via des informations disponibles sur le bus de données et délivrées par un système de refroidissement. L'invention fonctionne aussi dans le cas d'un véhicule sans système de refroidissement. Dans ce cas, les informations sont apprises pour définir le modèle et la mesure de température extérieure suffit.

Si l'on étudie les équations décrites ci-dessous, décrivant le comportement thermique d'un module, on remarque que la résistance interne intervient dans la modélisation de la température des cellules. La dynamique de la résistance interne n'est pas modélisable à partir des données fournis, elle est donc supposée nulle.

$$\dot{T}cell = \frac{R \cdot Ibat^2}{k4} - \frac{Tcell - Tcap}{k1}$$

$$\dot{T}cap = \frac{Tcell - Tcap}{k1} - \frac{Tcap - Tpar}{k2}$$

$$\dot{T}par = \frac{Tcap - Tpar}{k2} - \frac{Tpar - Tair}{k3}$$

$$\dot{R} = 0$$

avec :

- Tcell : l'estimation de la température des cellules du module,
- Tcap : l'estimation de la température du capteur qui mesure l'air emprisonné à l'intérieur d'un module,
- Tpar : l'estimation de la température de la paroi du module,
- R : l'estimation de la résistance interne globale des cellules du module,
- Tair : la température de l'air (renseignée par le système de refroidissement),
- Ibat : l'intensité du courant de charge de la batterie.

Les points correspondent aux dérivées temporelles des variables de température. Les variables portant ce point traduisent donc la dynamique du système.

La dynamique de la résistance interne est inconnue et la valeur de la résistance interne est corrigée en utilisant la mesure du capteur de température. Ibat représente le courant de la batterie (estimé à partir de la tension de l'onduleur et la puissance prélevée au réseau électrique). Les paramètres ki représentent différentes capacités calorifiques massiques et différents coefficients d'échanges convectifs. Ces coefficients sont évalués expérimentalement. Cette modélisation permet de tenir compte du positionnement du capteur de température qui n'est pas placé au plus proche des cellules (contrainte liée au montage). Mis sous forme d'état (x=[Tcell Tcap Tpar R]), ces équations deviennent :

$$
\dot{x} = \begin{bmatrix} -\dfrac{1}{k1} & \dfrac{1}{k1} & 0 & \dfrac{Ibat^2}{k4} \\ \dfrac{1}{k1} & -\dfrac{1}{k1}-\dfrac{1}{k2} & \dfrac{1}{k2} & 0 \\ 0 & \dfrac{1}{k2} & -\dfrac{1}{k2}-\dfrac{1}{k3} & 0 \\ 0 & 0 & 0 & 0 \end{bmatrix} \cdot x + \begin{bmatrix} 0 \\ 0 \\ \dfrac{1}{k3} \\ 0 \end{bmatrix} \cdot u
$$

$$
y = \begin{bmatrix} 0 & 1 & 0 & 0 \end{bmatrix} \cdot x
$$

Avec u=Tair, déterminant les conditions de refroidissement des modules. L'écart entre la modélisation et la réalité est ensuite corrigé par la mesure de température :

$$
\begin{cases} \dot{\hat{x}} = A\hat{x} + Bu + K(y-\hat{y}) \\ \hat{y} = C\hat{x} \end{cases}
$$

Les variables possédant un accent circonflexe traduisent l'estimation en temps réel des variables décrites précédemment, y représente la mesure de température.

Les résultats expérimentaux montrent que l'estimation de la résistance interne, dans les cas nominaux (en l'absence de surcharge), reste stable autour de sa valeur réelle, tandis que dans le cas d'une surcharge, l'estimation de la valeur de la résistance interne (image du flux de chaleur produit dans le module) s'accroît considérablement.

L'estimation R de la valeur de résistance interne peut alors servir de critère pour détecter une surcharge. Ce critère utilisé dans une stratégie de comparaison permet de détecter de façon efficace la surcharge d'une cellule. Si l'un des critères est significativement différent des autres critères issus de modules comparables, alors il y a certainement un cas de surcharge d'une cellule. Ainsi, on compare le critère R estimé pour un module avec au moins un autre critère estimé pour au moins un autre module.

Le critère R proposé repose sur des techniques classiques d'observation (le critère est construit à partir d'un modèle de transfert thermique corrigé par l'erreur entre le modèle et la mesure). Les techniques classiques d'observation permettent de proposer un gain K garantissant la convergence de l'observation. Le critère R est le critère sorti de l'observateur.

En cas de surcharge les réactions parasites exothermiques génèrent un flux de chaleur non pris en compte dans la modélisation mentionnée plus haut, ce qui biaise l'estimation de la valeur de résistance interne obtenue grâce à la modélisation thermique, l'estimation de valeur de résistance thermique obtenue grâce au modèle thermique devenant bien supérieure à sa valeur réelle. Ce phénomène peut donc être utilisé pour arrêter la charge de la batterie et éviter une surcharge.

Ainsi, grâce au procédé de gestion selon l'invention, un modèle simple de transfert thermique couplé à une mesure de température permet d'estimer le flux de chaleur produit dans un module (ce qui revient à dériver de manière fiable un signal de mesure de température). Cette quantité de chaleur (matérialisée par la variable R) sert ensuite d'indicateur à une stratégie de détection de surcharge.

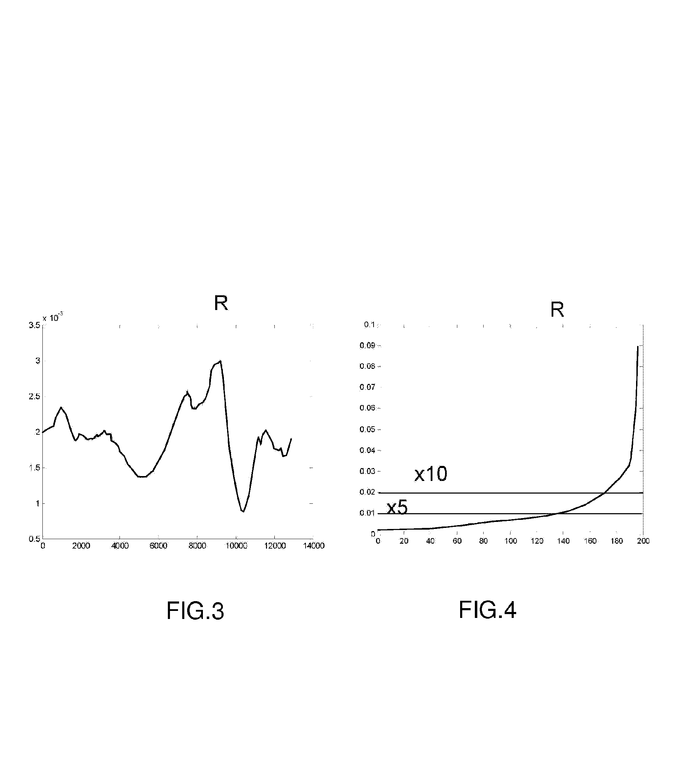

Sur la figure 3, on remarque que la variable R est sensiblement constante dans le temps lorsqu'un module n'est pas surchargé. Sur cette figure, les évolutions de la variable R sont représentées dans un diagramme présentant un axe d'ordonnées portant des Ohms et un axe d'abscisses portant des secondes.

Sur la figure 4, on remarque que la variable R augmente très fortement dès que le module est surchargé. Sur cette figure, les évolutions de la variable sont représentées dans un diagramme présentant un axe d'ordonnées portant des Ohms et un axe d'abscisses portant des minutes.

La valeur du critère R est par exemple fournie par le moyen de calcul 14.

## Revendications

1. Procédé de gestion de la charge d'une batterie (1) rechargeable comprenant au moins un module (2) incluant au moins une cellule électrochimique (3), le procédé comprenant une phase d'estimation d'un flux de chaleur produit dans l'au moins un module, le procédé étant **caractérisé en ce que** l'estimation du flux est réalisée par utilisation d'un observateur de gain K estimant la résistance interne globale des cellules du module, la phase d'estimation comprenant une étape de définition d'un modèle thermique de l'au moins un module et une étape de mesure d'une température de l'au moins un module, la résistance interne étant :

   • estimée à partir de la température obtenue à partir du modèle thermique, puis ;
   • corrigée en utilisant la mesure d'un capteur de température, le gain K étant choisi de sorte à faire converger l'observateur.

2. Procédé selon la revendication 1, **caractérisé en ce qu'**on utilise l'estimation du flux de chaleur produit dans l'au moins un module pour déterminer une commande d'arrêt de la charge de l'au moins un module ou de la batterie.

3. Procédé selon l'une des revendications précédentes, **caractérisé en ce qu'**on arrête la charge de l'au moins un module ou de la batterie lorsque la résistance interne globale estimée dépasse un seuil prédéterminé ou est significativement différente des résistances internes estimées dans d'autres modules.

4. Support d'enregistrement de données lisible par un calculateur sur lequel est enregistré un programme informatique comprenant des moyens de codes de programme informatique de mise en oeuvre des phases et/ou des étapes du procédé de gestion selon l'une des revendications précédentes.

5. Dispositif (10) de gestion de la charge d'une batterie (1) rechargeable comprenant au moins un module (2) incluant au moins une cellule électrochimique (3), **caractérisé en ce qu'**il comprend des moyens matériels (4, 6, 7) et/ou logiciels de mise en oeuvre du procédé de gestion selon l'une des revendications 1 à 4.

6. Dispositif selon la revendication précédente, **caractérisé en ce que** les moyens matériels et/ou logiciels comprennent un moyen d'estimation du flux de chaleur produit dans l'au moins un module.

7. Dispositif selon la revendication précédente, **caractérisé en ce que** le moyen d'estimation du flux de chaleur produit dans l'au moins un module comprend un moyen (4) de mesure d'une température du module comprenant ladite une ou plusieurs cellules et un moyen (15) de modélisation thermique de l'au moins une cellule.

8. Dispositif selon l'une des revendications 6 à 7, **caractérisé en ce qu'**il comprend un chargeur (5) de batterie et un moyen (6) de pilotage du chargeur de batterie et/ou un interrupteur commandé (7) pour connecter ou déconnecter le chargeur de batterie à l'au moins un module.

9. Véhicule automobile, en particulier véhicule automobile électrique ou hybride, comprenant un dispositif selon l'une des revendications 6 à 8.

10. Programme informatique comprenant un moyen de code de programme informatique adapté à la réalisation des phases et/ou des étapes du procédé selon l'une des revendications 1 à 3, lorsque le programme tourne sur un ordinateur ou un calculateur embarqué.

## Patentansprüche

1. Verfahren zur Verwaltung des Ladens einer wiederaufladbaren Batterie (1), die mindestens ein Modul (2) enthält, das mindestens eine elektrochemische Zelle (3) umfasst, wobei das Verfahren eine Phase des Schätzens eines in dem mindestens einen Modul erzeugten Wärmeflusses enthält, wobei das Verfahren **dadurch gekennzeichnet ist, dass** die Schätzung des Flusses durch die Verwendung eines Beobachters einer Verstärkung K durchgeführt wird, der den globalen inneren Widerstand der Zellen des Moduls schätzt, wobei die Schätzphase einen Schritt der Definition eines Wärmemodells des mindestens einen Moduls und einen Schritt der Messung einer Temperatur des mindestens einen Moduls enthält, wobei der innere Widerstand:

• ausgehend von der ausgehend vom Wärmemodell erhaltenen Temperatur geschätzt wird, dann
• korrigiert wird, indem der Messwert eines Temperaturfühlers verwendet wird, wobei die Verstärkung K so gewählt wird, dass sie den Beobachter konvergieren lässt.

2. Verfahren nach Anspruch 1, **dadurch gekennzeichnet, dass** die Schätzung des in dem mindestens einen Modul erzeugten Wärmeflusses verwendet wird, um einen Stoppbefehl des Ladevorgangs des mindestens einen Moduls oder der Batterie zu bestimmen.

3. Verfahren nach einem der vorhergehenden Ansprüche, **dadurch gekennzeichnet, dass** der Ladevorgang des mindestens einen Moduls oder der Batterie gestoppt wird, wenn der geschätzte globale innere Widerstand eine vorbestimmte Schwelle überschreitet oder deutlich anders ist als die geschätzten inneren Widerstände in anderen Modulen.

4. Rechnerlesbarer Datenspeicherträger, auf dem ein EDV-Programm gespeichert ist, das EDV-Programmcodeeinrichtungen zur Durchführung der Phasen und/oder der Schritte des Verwaltungsverfahrens nach einem der vorhergehenden Ansprüche enthält.

5. Vorrichtung (10) zur Verwaltung des Ladens einer wiederaufladbaren Batterie (1), die mindestens ein Modul (2) enthält, das mindestens eine elektrochemische Zelle (3) umfasst, **dadurch gekennzeichnet, dass** sie Hardware-Einrichtungen (4, 6, 7) und/oder Software-Einrichtungen zur Anwendung des Verwaltungsverfahrens nach einem der Ansprüche 1 bis 4 enthält.

6. Vorrichtung nach dem vorhergehenden Anspruch, **dadurch gekennzeichnet, dass** die Hardware- und/oder Softwareeinrichtungen eine Schätzeinrichtung des in dem mindestens einen Modul erzeugten Wärmeflusses enthalten.

7. Vorrichtung nach dem vorhergehenden Anspruch, **dadurch gekennzeichnet, dass** die Schätzeinrichtung des in dem mindestens einen Modul erzeugten Wärmeflusses eine Messeinrichtung (4) einer Temperatur des die eine oder mehreren Zellen enthaltenden Moduls und eine Einrichtung (15) zur Wärmemodellisierung der mindestens einen Zelle enthält.

8. Vorrichtung nach einem der Ansprüche 6 bis 7, **dadurch gekennzeichnet, dass** sie ein Batterieladegerät (5) und eine Steuereinrichtung (6) des Batterieladegeräts und/oder einen gesteuerten Schalter (7) enthält, um das Batterieladegerät mit dem mindestens einen Modul zu verbinden oder davon zu trennen.

9. Kraftfahrzeug, insbesondere Elektro- oder Hybrid-Kraftfahrzeug, das eine Vorrichtung nach einem der Ansprüche 6 bis 8 enthält.

10. EDV-Programm, das eine EDV-Programmcodeeinrichtung enthält, die für die Durchführung der Phasen und/oder der Schritte des Verfahrens nach einem der Ansprüche 1 bis 3 geeignet ist, wenn das Programm auf einem bordseitigen Computer oder Rechner läuft.

**Claims**

1. Method for managing the charging of a rechargeable battery (1) comprising at least one module (2) which includes at least one electrochemical cell (3), the method comprising a phase of estimating a heat flow produced in the at least one module, the method being **characterized in that** the estimation of the flow is carried out by using an observer of gain K estimating the overall internal resistance of the cells of the module, the estimating phase comprising a step of defining a thermal model of the at least one module and a step of measuring a temperature of the at least one module, the internal resistance being:

• estimated from the temperature obtained from the thermal model, then;

• corrected by using the measurement from a temperature sensor, the gain K being chosen so as to make the observer converge.

2. Method according to Claim 1, **characterized in that** the estimation of the heat flow produced in the at least one module is used to determine an order to stop the charging of the at least one module or of the battery.

3. Method according to either of the preceding claims, **characterized in that** charging of the at least one module or of the battery is stopped when the estimated overall internal resistance exceeds a predetermined threshold or is significantly different compared to estimated internal resistances in other modules.

4. Data storage medium readable by a computer on which is stored a computer program comprising computer program code means for carrying out the phases and/or steps of the management method according to one of the preceding claims.

5. Device (10) for managing the charging of a rechargeable battery (1) comprising at least one module (2) which includes at least one electrochemical cell (3), **characterized in that** it comprises hardware (4, 6, 7) and/or software means for carrying out the management method according to one of Claims 1 to 4.

6. Device according to the preceding claim, **characterized in that** the hardware and/or software means comprise a means for estimating the heat flow produced in the at least one module.

7. Device according to the preceding claim, **characterized in that** the means for estimating the heat flow produced in the at least one module comprises a means (4) for measuring a temperature of the module comprising said one or more cells and a means (15) for thermal modeling of the at least one cell.

8. Device according to either of Claims 6 and 7, **characterized in that** it comprises a battery charger (5) and a means (6) for manipulating the battery charger and/or an interrupter (7) controlled so as to connect or disconnect the battery charger to/from the at least one module.

9. Motor vehicle, in particular an electric or hybrid motor vehicle, comprising a device according to one of Claims 6 to 8.

10. Computer program comprising a computer program code means designed to implement the phases and/or steps of the method according to one of Claims 1 to 3 when the program runs on an on-board processor or computer.

## FIG.1

## FIG.2

CAN data

Sensor
Temperature

Filtering

Criterion

Calculation

**Module
processing:**

-Threshold

-Derivative,
2nd deriv

-Variation
after 2s, 5s

- Embedded
model

Multi - Sensor

Abnormal Behavior

Detection

Confirmation

Elapsed time

2+ Criteria

OverTemp
Detection Flag

R

FIG.3

R

FIG.4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050137823 A
- JP 2010016944 B
- FR 2926165
- EP 2131440 A
- US 2009058366 A
- US 6285163 B